# FASCICULE DE BREVET EUROPEEN

(11) **EP 2 030 231 B1**
(45) Date de publication et mention de la délivrance du brevet: **15.12.2010**
(21) Numéro de dépôt: 07788866.7
(22) Date de dépôt: 11.06.2007
(51) Int. Cl.: H01L 21/762

(54) **PROCEDE ET DISPOSITIF DE SUIVI D'UN TRAITEMENT THERMIQUE D'UN SUBSTRAT MICROTECHNOLOGIQUE**
VERFAHREN UND VORRICHTUNG ZUR ÜBERWACHUNG EINER WÄRMEBEHANDLUNG EINES MIKROTECHNOLOGISCHEN SUBSTRATS
METHOD AND DEVICE FOR MONITORING A HEAT TREATMENT OF A MICROTECHNOLOGICAL SUBSTRATE

(30) Priorité: 22.06.2006 FR 0605620
(43) Date de publication de la demande: 04.03.2009
(73) Titulaire: Commissariat à l'Énergie Atomique et aux Énergies Alternatives, 75015 Paris (FR)
(72) Inventeur: SANCHEZ, Loic, F-38140 La Murette (FR)
(74) Mandataire: Quantin, Bruno Marie Henri
(86) Numéro de dépôt international: PCT/FR2007/000961
(87) Numéro de publication internationale: WO 2007/147956

(56) Documents cités:
- EP-A1- 0 938 129
- EP-A1- 1 014 452
- US-A- 5 909 627
- US-B1- 6 387 829

## Description

### Domaine de l'invention

L'invention concerne le suivi d'un traitement thermique d'un substrat microtechnologique (on parle aussi de structure microtechnologique, étant précisé que ce substrat peut être formé de plusieurs couches dont certaines peuvent être en soi un substrat).

Elle vise notamment, mais pas exclusivement, la production de couches microtechnologiques, obtenues par exemple par fragilisation et séparation au sein d'un substrat microtechnologique (notamment en matériau semi-conducteur), voire par séparation au niveau d'un interface de collage au sein d'un tel substrat microtechnologique.

De manière générale, ces couches microtechnologiques sont réalisées par des techniques de fabrication à l'échelle submicronique, incluant les technologies de la microélectronique et les technologies de fabrication des microsystèmes (micro usinage, etc.). Ces couches peuvent être dites minces (typiquement de l'ordre de, voire inférieure à, un micron) ou plus épaisses (avec une épaisseur pouvant atteindre celle d'un substrat en tant que tel, c'est-à-dire typiquement de l'ordre de quelques centaines de microns, par exemple 700 microns pour une plaquette de 200 mm de diamètre).

L'invention vise en particulier le suivi du traitement thermique que comporte en pratique la production de telles couches microtechnologiques en vue de cette séparation, que cette séparation soit prévue au terme de ce traitement thermique, ou que cette séparation soit prévue ultérieurement.

Elle s'applique notamment, mais pas exclusivement, à la mise en oeuvre du procédé appelé « Smart Cut © », tel qu'il est notamment décrit dans le document US - 5 374 564.

### Etat de la technique

Comme indiqué notamment dans le document précité, le procédé « Smart Cut® » consiste à implanter un substrat de départ 1 (tel qu'une plaque ou plaquette de silicium en pratique oxydée en surface) avec des ions hydrogènes (voir la figure 1) pour créer une zone fragilisée 3 (voir la figure 2). On vient ensuite reporter cette première plaque sur un second substrat 4 (par exemple une seconde plaque, ou plaquette, de silicium) par une technique de collage appropriée (voir la figure 3), par exemple un collage moléculaire. L'ensemble ainsi collé est ensuite placé dans un four pour subir un recuit durant lequel les défauts coalescent (voir la figure 4) et au bout duquel un transfert d'une couche, par exemple mince, va avoir lieu (voir la figure 5), c'est-à-dire que la couche 1A du substrat de départ située entre la surface et la zone fragilisée se détache du reste de ce substrat de départ en restant collée au second substrat.

Il s'agit d'un processus activé thermiquement qui conduit au mûrissement des défauts générés par la fragilisation et à la propagation de micro-fissures (découlant de ces défauts) jusqu'au transfert complet de la couche microtechnologique, par séparation ou fracture le long de la zone fragilisée.

Typiquement l'épaisseur de la couche ainsi obtenue, lorsqu'elle est mince (on parle parfois aussi de film), est de quelques centaines de nanomètres tandis que l'épaisseur du substrat est d'environ 700µm (voir ci-dessus) ; on comprend que le substrat de départ peut ensuite faire l'objet d'une réitération du procédé en sorte de former successivement plusieurs couches minces.

Dans une première forme de mise en oeuvre du procédé, le transfert a lieu au cours du traitement thermique (éventuellement combiné à l'application d'efforts complémentaires, tels que des contraintes mécaniques), tandis que dans une seconde forme de mise en oeuvre, ce traitement thermique est suivi d'un traitement complémentaire (impliquant par exemple l'application d'efforts, tels que des contraintes mécaniques) au cours duquel intervient le transfert.

Selon que le traitement thermique est destiné à provoquer la séparation de transfert ou qu'au contraire il doit être interrompu avant une telle séparation, on comprend l'intérêt qu'il peut y avoir à savoir mesurer la durée du recuit ayant entraîné une telle séparation ou définir le moment où cette séparation intervient. En effet, dans le cas où la séparation doit intervenir au cours du traitement thermique, il est inutile de prolonger ce traitement thermique au-delà de la séparation, pour des raisons évidentes d'économie d'énergie ; et dans le cas où, par contre, la séparation ne doit intervenir qu'au-delà du traitement thermique, il peut être intéressant, par sécurité, de pouvoir détecter qu'une séparation intempestive est intervenue en sorte d'interrompre le traitement thermique avant que d'autres pièces d'un même lot ne subissent également une séparation intempestive ; il est rappelé ici que la production de couches microtechnologiques est souvent conduite par lots, et il est intéressant de pouvoir interrompre le traitement thermique au plus tard au moment où l'une des pièces en cours de traitement fait l'objet d'une séparation, en sorte de pouvoir préserver les autres pièces, de même que l'équipement dans lequel le traitement thermique est effectué en évitant une contamination trop importante due à la casse de ces pièces.

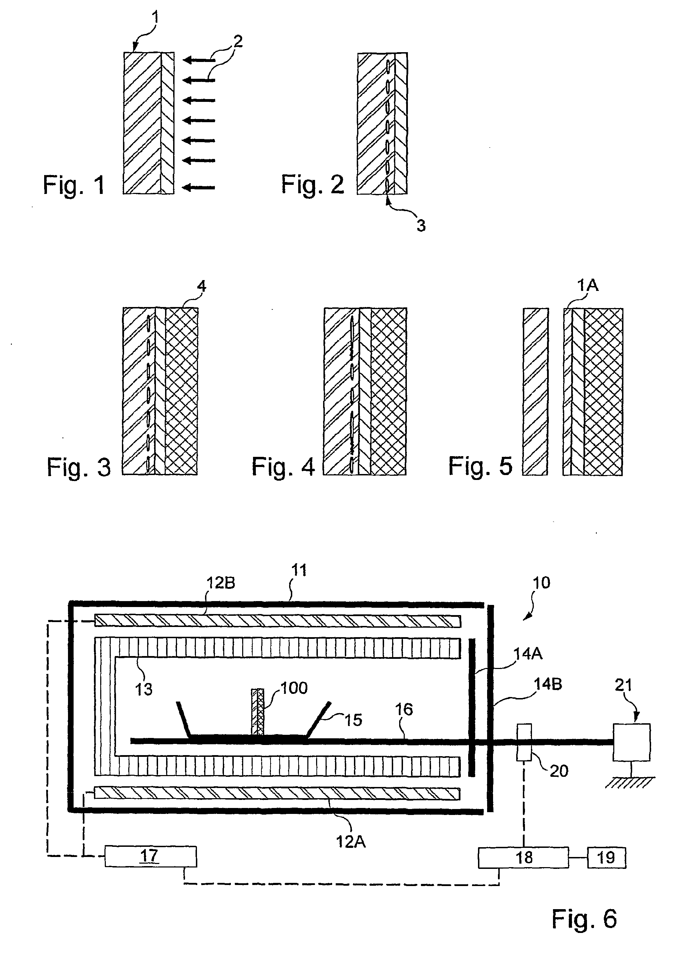

Le document US-A-5 909 627 décrit un procédé de séparation d'une couche mince vis-à-vis d'un substrat donneur par implantation dans ce dernier d'une espèce gazeuse (ions deutérium) puis, après collage à un raidisseur, par chauffage. De manière à démontrer que la région d'implantation est une région de fortes contraintes qui sont relaxées par le traitement thermique, l'exemple 2 mentionne un suivi de l'état de contraintes (voir la figure 3) par chauffage au sein d'un outil de mesure de contraintes (il n'y a pas de raidisseur puisqu'il est aussi prévu de mesurer l'état de contraintes par la mesure des ondulations du substrat) ; ce suivi de contraintes est effectué lorsque la température augmente puis diminue.

### Problème technique

On comprend en conséquence l'intérêt qu'il y a à être capable de détecter cette fracture ou séparation, et ce d'une manière automatique ou au moins automatisable. Le fait de savoir mesurer la durée du traitement thermique avant séparation de transfert ou de savoir détecter une telle séparation est en particulier intéressant lorsqu'on applique la technologie de séparation à des substrats en des matériaux nouveaux, c'est-à-dire lorsqu'on ne dispose pas encore de données suffisantes pour pouvoir prédire une durée optimale pour ce traitement thermique.

Jusqu'à présent cette détection est réalisée à l'oreille, en profitant de ce que la fracture émet un son en principe audible, ce qui demande beaucoup d'attention pour être discerné avec certitude, compte tenu de l'environnement généralement bruyant, surtout si il y a un lot de pièces dont on veut détecter les fractures respectives. Les sources de bruits parasites sont notamment : la ventilation parfois forte (dans la pièce contenant le four), la manipulation d'une porte qui s'ouvre ou se ferme, le passage de personnes dans la pièce, etc. Il est précisé ici que la température des traitements thermiques de transfert peut être de plusieurs centaines de °C et leurs durées peuvent être de quelques minutes à plusieurs heures.

Cette détection est donc actuellement une démarche à la fois pénible et souvent entachée d'une incertitude non négligeable.

L'invention a pour objet de permettre de rendre moins pénible et plus fiable cette détection de séparation (ou de fracture), et de permettre des mesures systématiques de durée de traitement thermique.

On comprend que l'invention vise ainsi, dans un contexte industriel, de permettre de limiter le temps de traitement thermique à ce qui est nécessaire pour obtenir la séparation (et, en conséquence, améliorer la disponibilité des équipements, réduire les coûts de fabrication, etc.). Elle peut également permettre de garantir que toutes les pièces faisant partie d'un même lot en cours de traitement sont bien fracturées avant d'interrompre le traitement thermique (gain en rendement...). A l'inverse, lorsque le traitement thermique n'est pas destiné à engendrer une séparation, l'invention vise à permettre de détecter des séparations intempestives et permettre de préserver les autres pièces du même lot et/ou l'équipement dans lequel s'effectue le traitement thermique.

### Définition de l'invention

L'invention propose à cet effet un procédé de suivi d'un traitement thermique d'un substrat microtechnologique, comportant les étapes suivantes :
- placer ce substrat à traiter dans une zone de chauffage,
- appliquer audit substrat à traiter un traitement thermique dans des conditions de température prédéterminées, tout en surveillant l'évolution au cours du temps de l'état mécaniquement vibratoire (c'est-à-dire des mouvements) de ce substrat à traiter,
- détecter une fracture du substrat à traiter par reconnaissance, dans l'évolution de l'état vibratoire au cours du temps, d'un pic caractéristique d'une fracture.

Ce suivi peut intervenir, ou non, dans la production de couches microtechnologiques.

Selon des caractéristiques préférées de l'invention, éventuellement combinées :
- l'on surveille l'évolution au cours du temps de l'état vibratoire du substrat à traiter par surveillance de l'état vibratoire d'un support sur lequel ce substrat à traiter est situé, ce qui évite d'avoir à venir au contact direct avec le substrat,
- le support comporte une partie située à l'extérieur de la zone de chauffage et la surveillance de son état vibratoire se fait à partir de cette partie située à l'extérieur, ce qui facilite l'implantation de la mesure de vibrations,
- le traitement thermique étant destiné à la production de couches microtechnologiques, on applique au substrat à traiter, préalablement au traitement thermique, une préparation qui comporte une fragilisation par implantation d'ions ou d'espèces gazeuses, ce qui est une technique bien connue pour la préparation de couches minces, notamment selon le procédé « Smart Cut © »,
- cette préparation comporte la solidarisation de ce substrat fragilisé à un second substrat, ce qui est classique en soi lorsque la future couche mince est trop mince pour pouvoir être ultérieurement manipulée sans la dégrader,
- préalablement au traitement thermique, on applique au substrat une préparation qui comporte le collage de ce substrat à un second substrat, de préférence par collage moléculaire, ce qui peut correspondre à une grande variété de traitements en microtechnologie,
- le substrat est à base de silicium, ce qui est un matériau couramment utilisé pour la fabrication de couches minces, même si l'invention s'applique aussi à des substrats réalisés en un matériau sur lequel on a peu ou pas de données sur le comportement en traitement thermique,
- l'on surveille l'état vibratoire au moyen d'un capteur de vibrations, de préférence un capteur piézo-électrique,
- le traitement thermique ayant pour fonction de provoquer au moins une fracture de substrat pour la formation de couches microtechnologiques, on interrompt le traitement thermique lorsqu'on a détecté un nombre de pics correspondant au nombre de fractures de substrats attendu en conséquence du traitement thermique ; de manière avantageuse, l'on prépare plusieurs substrats, on les met dans la zone de chauffage sur un même support, on applique un même traitement thermique auxdits substrats en surveillant l'état vibratoire dudit support, le nombre de fracture de substrats attendu étant égal au nombre desdits substrats,
- en variante (lorsque ce traitement thermique n'est pas prévu pour engendrer une fracture pendant ce seul traitement ou vise au contraire à préserver l'intégrité des substrats), on prépare plusieurs substrats, on les met dans la zone de chauffage sur un même support, on applique un même traitement thermique auxdits substrats en surveillant l'état vibratoire dudit support, et on interrompt le traitement thermique dès qu'une fracture est détectée,
- on reconnaît un pic caractéristique d'une fracture par la présence d'alternances rapprochées et d'amplitudes décroissantes.

L'invention propose en outre un dispositif adapté à la mise en oeuvre du procédé précité, lorsque l'on surveille l'état vibratoire du substrat par l'intermédiaire de celui de son support.

Elle propose ainsi un dispositif de suivi d'un traitement thermique d'un substrat microtechnologique, comportant :
- un four comportant un support adapté à recevoir des substrats à traiter,
- un dispositif de commande de ce four,
caractérisé en ce qu'il comporte en outre un capteur de vibrations mécaniques adapté à capter des vibrations subies par le support, ce capteur étant relié à un ensemble de traitement du signal de ce capteur.

Comme pour le procédé, le traitement thermique peut être destiné, ou non, à provoquer la séparation d'une couche microtechnologique.

Selon des caractéristiques préférées, éventuellement combinées :
- l'ensemble de traitement est connecté au dispositif de commande du four,
- le capteur est un capteur piézo-électrique.

### Description de l'invention

Des objets, caractéristiques et avantages de l'invention ressortent de la description qui suit, donnée à titre d'exemple illustratif non limitatif, en regard des dessins annexés sur lesquels :
- la figure 1 est un schéma représentant une première étape du procédé « Smart Cut © », dans une version connue,
- la figure 2 est un schéma du résultat de cette première étape,
- la figure 3 est un schéma d'une seconde étape de ce procédé,
- la figure 4 est un schéma d'une troisième étape de ce procédé,
- la figure 5 est un schéma montrant le résultat de cette troisième étape,
- la figure 6 est un schéma de principe d'un four mettant en oeuvre le procédé de l'invention,

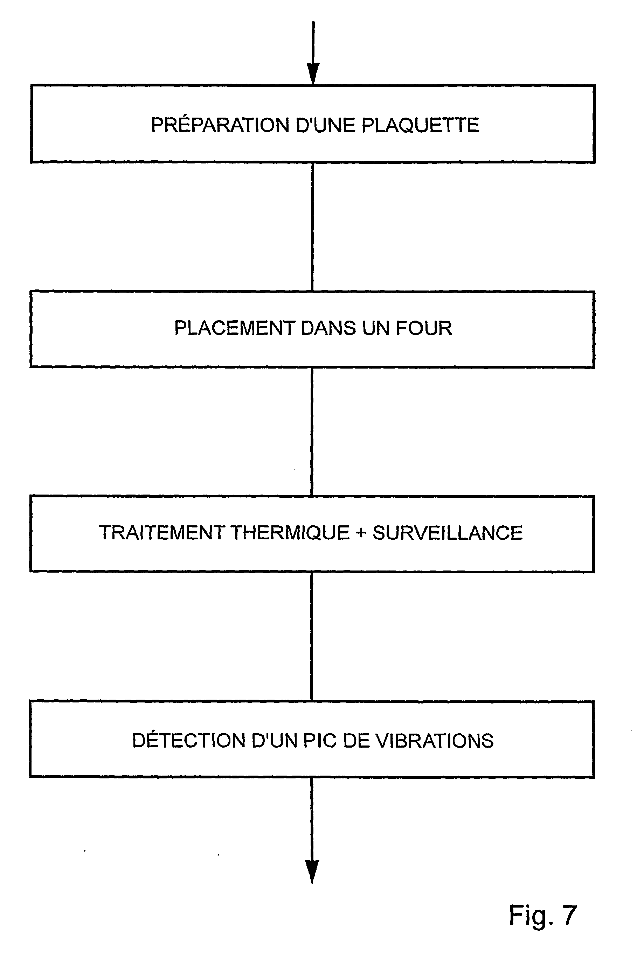

- la figure 7 est un schéma des étapes principales du procédé de l'invention,

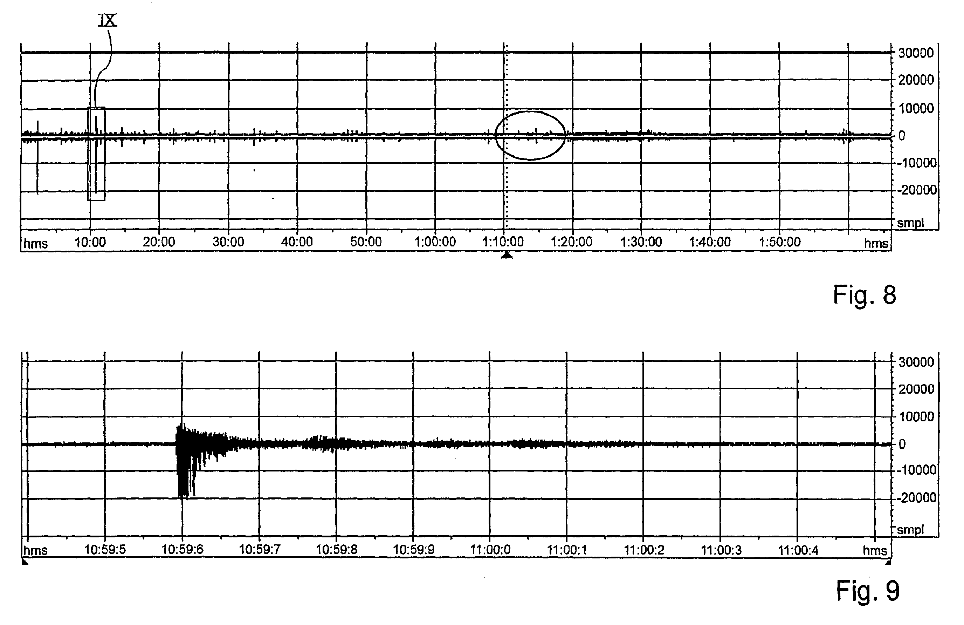

- la figure 8 est un graphe montrant les vibrations observées lors d'un premier exemple de mise en oeuvre de l'invention,
- la figure 9 est un graphe représentant de manière agrandie, en largeur, la partie du graphe de la figure 8 entourée par un rectangle repéré IX,

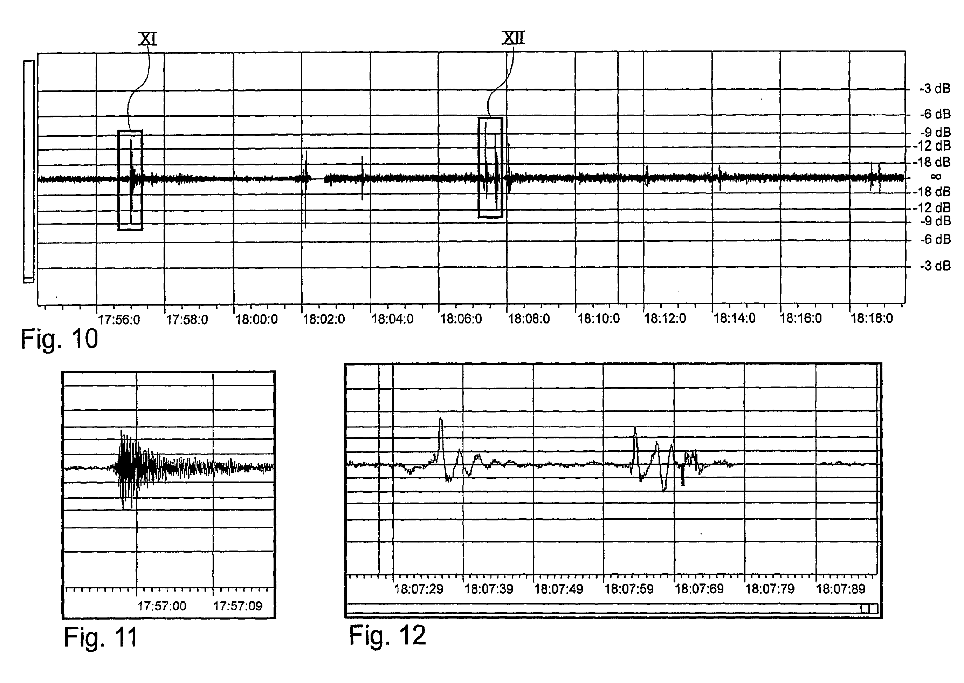

- la figure 10 est un graphe similaire à celui de la figure 8, mais correspondant à un second exemple de mise en oeuvre,
- la figure 11 est un agrandissement du détail du graphe de la figure 10 délimité dans le rectangle repéré XI à gauche, correspondant à une fracture,
- la figure 12 est un agrandissement du détail du graphe de la figure 10 délimité par le rectangle le plus à droite, repéré XII,

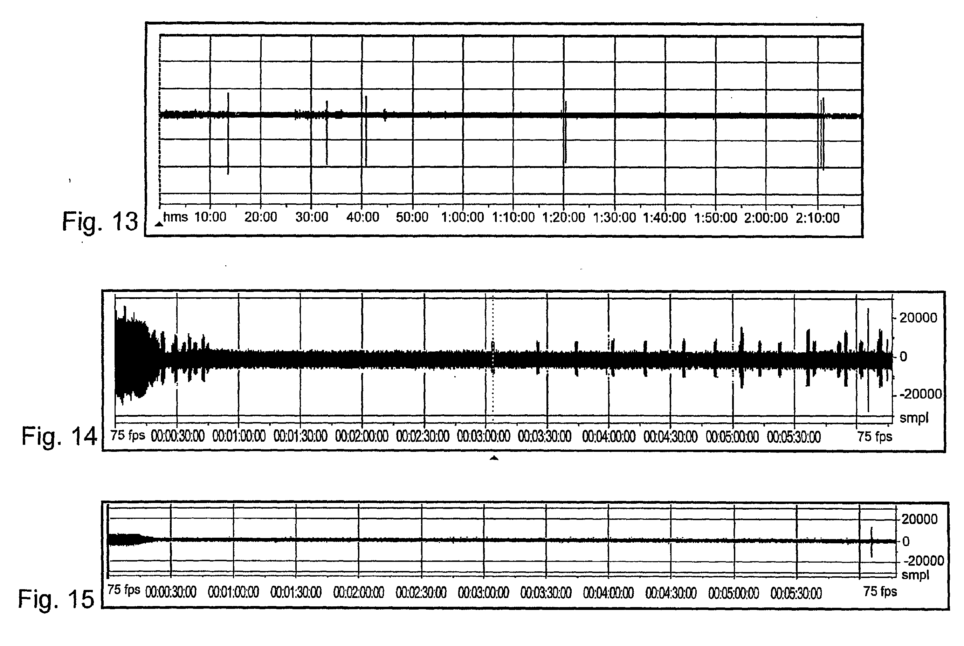

- la figure 13 est un graphe similaire à celui des figures 8 et 10 mais correspondant à un troisième exemple de mise en oeuvre, avec un lot de 7 plaquettes à fracturer,
- la figure 14 est un graphe correspondant à encore un autre mode de mise en oeuvre de l'invention, et
- la figure 15 est un graphe correspondant au graphe brut de la figure 14, après filtrage.

La figure 6 représente un exemple de four de recuit 10 adapté à la mise en oeuvre de l'invention. Il s'agit d'un four dit horizontal dans lequel l'ensemble à traiter est inséré par un mouvement de translation horizontal.

Dans la suite on considère, à titre d'exemple, le cas d'une production de couches minces.

Ce four comporte un bâti 11 muni d'éléments chauffants 12A et 12B, ici situés en partie inférieure et en partie supérieure du volume intérieur du bâti ; ces éléments peuvent faire partie d'un même ensemble cylindrique lorsque le bâti est de forme cylindrique. Entre ces éléments chauffants 12A et 12B est disposé une chambre de chauffage 13, ici formée d'un tube de quartz. Cette chambre de chauffage est ici fermée par un ou plusieurs écrans thermiques (ici au nombre de deux et notés 14A et 14B. Dans la chambre de chauffage est disposé un substrat microtechnologique à traiter (ou plaquette) 100, conforme à l'ensemble de la figure 3, c'est à dire comportant un substrat préalablement fragilisé en sorte de délimiter une couche mince et un second substrat sur lequel on veut transférer cette couche mince. Cet ensemble à traiter 100 est disposé sur un support, ici formé d'une nacelle 15, elle-même portée par une pelle de four 16 grâce à laquelle l'ensemble 100 a pu être amené dans le four. Les écrans thermiques 14A et 14B sont en général solidaires de la pelle 16, et viennent fermer la chambre de chauffage lorsque la pelle est suffisamment avancée dans le four. Un dispositif de maintien 21 permet ici d'assurer le maintien mécanique en position de la pelle 16 lorsque le four est fermé. Ce dispositif de maintien peut assurer en outre le déplacement de la pelle entre ses positions entrée et sortie, par exemple au moyen d'un rail de guidage (non représenté).

Cette pelle 16 comporte, de part et d'autre des écrans, une partie (à gauche) située dans le four et une partie (à droite, en pratique une tige) située en dehors du four. Les éléments chauffants sont classiquement reliés à un bloc d'alimentation et de commande 17.

Le four est, pour la mise en oeuvre de l'invention, en outre muni d'un capteur de vibrations 20 au moins indirectement en contact avec la plaquette 100. Ce capteur est, dans la figure 6, monté sur la partie externe de la pelle de four 16 ; il est donc en contact avec la plaquette 100 par l'intermédiaire de la partie gauche de la pelle et de la nacelle. Puisqu'il détecte des vibrations de mouvement (ou des mouvements vibratoires), on peut dire qu'il s'agit d'un capteur de vibrations mécaniques.

En variante non représentée, ce capteur de vibrations est monté sur une autre partie du support de la plaquette, par exemple sur la nacelle. Il peut aussi, en variante, être monté sur l'un des écrans (ou les deux) ou sur le dispositif de maintien 21, ou plus généralement sur toute pièce susceptible de vibrer suite à la vibration de la plaquette 100.

En fait, le fait de monter le capteur sur une partie externe du support de la plaquette (ou liée à celui-ci) présente l'avantage de ne pas soumettre ce capteur à la chaleur à laquelle est soumise la plaquette, et d'éviter toute contamination de la chambre de chauffage par ledit capteur. Par contre, le fait de monter le capteur au plus près de la plaquette, par exemple à l'intérieur du four, a l'avantage de permettre l'acquisition d'un signal de plus grande amplitude et donc de détecter plus facilement la fracture éventuelle. Cela oblige cependant ce capteur à supporter le même environnement thermique que la plaquette à traiter ; mais il est à la portée de l'homme de métier de choisir des capteurs de vibrations résistant aux températures nécessaires pour le traitement des plaquettes à traiter (elles dépendent du matériau constitutif des substrats utilisés). Un tel capteur sera cependant en principe plus cher que ceux qui peuvent être placés à l'extérieur du four.

Ce capteur de vibrations est par exemple un capteur piézo-électrique. En variante, il peut s'agir d'autres types de capteurs de vibrations (on peut citer les sondes capacitives, les sondes à courant de Foucault, les bobines mobiles, des capteurs piézorésistifs, etc.).

Ce capteur délivre un signal traité par un ensemble de traitement 18 comportant un logiciel approprié en sorte de permettre de suivre l'évolution au cours du temps de l'état vibratoire du capteur, ainsi que cela sera décrit plus loin. Le choix de ce logiciel est à la portée de l'homme de métier, compte tenu des indications qui seront données plus loin et de ses connaissances générales. Ce logiciel peut permettre l'enregistrement de cette évolution au cours du temps ainsi que la détection d'un pic caractéristique d'une fracture et, éventuellement, déclencher en conséquence une action sur l'alimentation du four (par exemple déclencher une phase de refroidissement). L'ensemble 18 comporte avantageusement un dispositif d'affichage 19 et est avantageusement connecté à l'alimentation en sorte de pouvoir, le cas échéant, influer sur le fonctionnement du four, si l'opérateur le souhaite, lors de la détection d'une fracture.

La figure 7 représente ainsi les principales étapes du procédé de suivi de traitement thermique du substrat 100, dans le cas ici considéré d'une production de couches minces, conformément à l'invention :
- étape 1 (optionnelle) : on prépare, de manière connue, une plaquette avantageusement fragilisée (telle que celle de la figure 1),
- étape 2 : on place cette plaquette dans un four, par exemple sur un support,
- étape 3 : on fait subir à cette plaquette un traitement thermique dans des conditions de températures prédéterminées, tout en surveillant l'évolution au cours du temps de l'état vibratoire de la plaquette (ici par l'intermédiaire de celui du support),
- étape 4 : on détecte une fracture de la plaquette fragilisée par reconnaissance dans l'évolution de l'état vibratoire au cours du temps d'un pic de caractéristiques prédéterminées. On peut alors, si cela est souhaité, déclencher une action sur l'alimentation de la zone de chauffage.

Il est à noter que, dans le cas où l'on cherche à produire des couches microtechnologiques de grande épaisseur (par exemple de l'ordre du micron), il peut ne pas être nécessaire de coller le premier substrat à un second substrat pour permettre une manipulation ultérieure de la couche mince après séparation.

Il est à la portée de l'homme de métier de définir, par quelques essais simples, les caractéristiques d'un pic représentatif d'une fracture ; cela sera détaillé plus loin.

Deux types d'essais ont été effectués, dans deux fours différents. C'est ainsi que des recuits de fracture ont été effectués dans un four TEMPRESS horizontal 200 mm en salle blanche (particulièrement bien adapté pour la fracture d'une plaque complète ; il peut s'agir de disques de plus de 20 centimètres de diamètre) ; ce four est conforme au schéma de la figure 6. D'autres essais ont été effectués dans un four AET horizontal 100 mm hors salle blanche (particulièrement bien adapté pour la fracture de morceaux de plaque, donc pour des ensembles à traiter plus petits que des disques précités). En fait, le schéma général de la figure 6 s'applique aussi à ce second four. Bien sûr, l'invention peut être mise en oeuvre dans d'autres types de four ou de bâti de traitement thermique, notamment des fours verticaux, dès lors que la vibration de la plaquette est bien transmise avec une amplitude suffisante.

On appréciera que, dans les deux cas, l'environnement peut être bruyant, avec notamment des évènements tels que des cycles de fonctionnement d'une ventilation puissante, les mouvements d'une porte qui s'ouvre et se ferme, le passage de personnes, etc. Il est rappelé que la température des recuits peut être de quelques centaines de °C et leurs durées peuvent aller, selon les matériaux et les températures choisies, aller de quelques minutes à peine, à plusieurs heures.

Des enregistrements sonores ont été tenté mais ont bien moins donné satisfaction que des enregistrements réalisés, comme indiqué ci-dessus, à l'aide de capteurs de vibrations « solidaires » du point de vue vibratoire de l'ensemble à traiter, en pratique portés par le support de cet ensemble à traiter, et pour lesquels les gammes de fréquences surveillées sont au moins en partie en dehors du domaine sonore.

Les essais ont été effectués à l'aide d'une pastille piezo-électrique (type buzzer de PC) dont le signal a été amplifié environ 20 fois. Ce signal a été enregistré via la prise micro d'une carte son d'un PC sous forme d'un fichier son (wav, wma ou mp3). Tous les résultats suivants ont été réalisés à partir de ce montage. Des essais sur les 2 types de four ont été effectués.

Les plaquettes à traiter (soit des disques complets, soit des morceaux) étaient en silicium, et les températures de traitement étaient de l'ordre de 500°C.

**Un premier essai a été conduit dans le premier four (200 mm en salle blanche) dans les conditions suivantes :**
- pastille piezo posée directement sur la tige de la pelle.
- détection de la fracture de deux plaques entières (diamètre 200 mm).

La figure 8 représente un graphe ainsi obtenu, avec le temps en abscisse (en millisecondes) et une unité arbitraire en ordonnée.

On observe une multitude de petits pics (dont l'un est entouré d'un ovale) : il s'agit de bruits résultant de la mesure et de l'environnement de la salle blanche.

On observe en outre deux pics bien nets, en partie gauche du graphe, qui descendent très nettement en dessous de la ligne médiane. Dans l'agrandissement du second pic représenté à la figure 9, on peut noter que ce pic, qui est représentatif d'une fracture, comporte une pluralité d'alternances très rapprochées et d'amplitudes décroissantes, suivies de quelques vibrations harmoniques à peine détectables .

**Un second essai a été conduit en présence de perturbations extérieures, dans les mêmes conditions de mesure que pour le premier essai, en vue de détecter la fracture d'une plaquette.**

On observe sur le graphe de la figure 10 divers types de pics, dont un pic, à gauche, dont l'agrandissement (voir la figure 11) montre, comme la figure 9, une pluralité d'alternances très rapprochées et d'amplitudes décroissantes, suivies de quelques vibrations résiduelles : ce pic est représentatif de la fracture de la plaquette en cours de traitement. Par contre, ainsi que cela ressort de la figure 12, les autres pics, plus étroits et situés plus au milieu du graphe, présentent un faible nombre d'alternances : ces pics correspondent à des perturbations extérieures (provoquées par un opérateur qui a tapé du coude conte le bâti du four).

**Un troisième essai a été effectué dans les mêmes conditions que précédemment, dans le cas où les pièces à traiter étaient constituées d'un lot de sept plaquettes.**

On observe sur le graphe de la figure 13 sept pics d'allure très voisine de celle des pics de la figure 8. Ces sept pics correspondent à la fracture des sept plaquettes à traiter. On peut noter que la première précède la dernière d'environ 2 heures ; il mérite d'être souligné que les deux dernières fractures sont quasi-simultanées (dans la même minute) mais ont généré des pics distincts.

**Un quatrième essai a été effectué dans le second four, à savoir le four situé à l'extérieur de la salle blanche, dans les conditions suivantes :**
- pastille piezo-électrique posée sur une pièce maintenant la tige de la pelle (la tige étant trop chaude pour la pastille, il y a sans doute perte de sensibilité)
- détection de la fracture d'un petit morceau de plaquette de quelques cm².

Ainsi, ayant décidé de considérer que la tige de pelle était trop chaude, la pastille a été posée sur la pièce 21 maintenant mécaniquement la tige de la pelle. Il est possible que cet éloignement du capteur vis-à-vis du morceau de plaquette (le contact entre ce capteur et le morceau de plaquette est établi par l'intermédiaire d'un plus grand nombre de pièces que pour les essais précédents) ait contribué à réduire la sensibilité du système, en combinaison avec le fait que la fracture d'un morceau de plaquette provoque bien sûr moins de vibrations que la fracture d'une plaquette complète.

On observe sur la figure 14 des petits pics de vibrations apparaissant assez régulièrement, sans doute provoqués par les cycles de mise en route de la régulation de chauffe, ainsi que, tout à fait à droite, un pic plus net dont l'allure semble correspondre à celle des pics, notamment, de la figure 13. L'application au signal brut de la figure 14 d'un filtre passe bande 800Hz-5000Hz (voir la figure 15) permet de confirmer que ce pic étroit tout à fait à droite est d'un type particulier; il a pu être vérifié que c'était bien un pic caractéristique de la fracture du morceau de plaquette en cours de traitement.

La validité du principe de détection est ainsi démontrée pour les deux fours choisis, et l'identification de pics caractéristiques d'une fracture est apparue possible et fiable (la signature d'une fracture est apparue être bien identifiable en amplitude et en fréquence, pour le silicium, mais il paraît tout à fait réaliste qu'il en serait de même pour d'autres matériaux).

Le montage qui a été décrit est très artisanal mais se prête sans difficulté à une optimisation en vue d'une meilleure ergonomie et une durée de vie compatible avec les besoins.

On comprend ainsi que l'invention propose une solution complète (capteur connu, conditionnement classique du signal du capteur, logiciel simple à mettre au point) capable de mesurer la durée d'un recuit ayant entraîné la fracture de un ou plusieurs ensembles à traiter au cours d'un traitement thermique de fracture, tel que celui mis en oeuvre selon la technologie « Smart Cut © ». Toutefois, le procédé de l'invention et le dispositif proposé pour sa mise en oeuvre s'applique plus généralement dès lors que l'on veut provoquer, dans un procédé de production de couches minces, une séparation au sein d'un substrat à l'aide d'un traitement thermique, que ce traitement thermique soit destiné à provoquer cette séparation (à lui seul ou en combinaison avec l'application d'effets complémentaires), soit que ce traitement thermique soit destiné à simplement préparer cette séparation, laquelle doit intervenir ultérieurement (dans ce dernier cas, l'invention permet de vérifier qu'il n'y a pas de séparation intempestive et, si nécessaire, détecter qu'il y a un risque de séparation de tout un lot de pièces avant que toutes ces pièces aient subi une séparation).

La détection se fait à partir du signal généré par un capteur de vibration, avantageusement un capteur piézoélectrique « solidaire » des ensembles (plaquettes, morceaux de plaquettes ou structures) à fracturer (ou à surveiller), cette solidarité signifiant qu'il y a une continuité de contact entre le capteur et la pièce à fracturer capable de transmettre des vibrations. La qualité de la transmission des vibrations par contact est bien entendu d'autant meilleure qu'il y a un faible nombre de pièces entre le capteur et la pièce à fracturer et que les contacts entre ces pièces sont étroits. Ce capteur peut être placé sur la structure, la nacelle, la pelle du four... Avantageusement, pour limiter les contraintes thermiques sur ce capteur (et éviter toute contamination du four), celui-ci est disposé à l'extérieur du four.

Plus généralement, l'invention s'étend à d'autres types de traitement thermiques intervenant dans la production de couches minces dans le domaine des microtechnologies. C'est ainsi qu'elle s'applique, notamment, à la détection d'une dissociation au niveau de l'interface de collage d'un couple de plaques collées (on parle couramment de hétérostructures lorsque les plaques sont en des matériaux différents) mais également à la détection d'une fracture intempestive d'un couple de plaques collées (à l'interface de collage ou ailleurs), lors de traitements thermiques, par exemple pour éventuellement bloquer le four (redescendre en température) dès qu'une fracture intempestive est détectée pour préserver les autres plaques et/ou l'équipement.

En effet, l'invention s'applique, de manière très générale, dès lors que l'on souhaite suivre un traitement thermique appliqué à un substrat microtechnologique, quelle que soit la fonction de ce traitement thermique.

En pratique il est recommandé que le capteur puisse supporter des températures d'au moins 80°C environ (ce qui est une température approximative de la tige de la pelle du four dans des cas tout à fait défavorables).

L'homme de métier n'aura aucune difficulté à mettre en oeuvre l'invention, compte tenu des informations précitées et de ses connaissances générales. C'est ainsi que par exemple, en ce qui concerne le logiciel il pourra le constituer avec trois parties (pouvant correspondre à trois fenêtres) :
- une partie paramètres,
- une partie mesure et
- une partie relecture et traitement d'un enregistrement de courbe.

Pour ce qui est des paramètres d'acquisition, il pourra les choisir par un choix approprié du paramétrage de la carte d'acquisition (gain, ...) (suivant ce que la carte d'acquisition permet) ; il pourra choisir de rendre actif ou non le filtre passe bande sur l'acquisition en temps réel et choisir à sa convenance les réglages des fréquences de coupures basses et hautes du filtre. En fait, le choix technique du (ou des) filtre(s) est libre mais il est recommandé que ces filtres soient paramétrable, avec notamment si un filtre passe bande est sélectionné, la possibilité de rentrer une fréquence de coupure égale à 0 ou bien infinie.

Il est également à la portée de l'homme de métier de régler les paramètres de détection (par exemple : seuil en amplitude ou/et en fréquence suivant la méthode de détection choisie).

La partie mesure correspond à l'acquisition proprement dite, avec les paramètres précités.

Quant à la partie relecture et/ou traitement, elle peut se faire en temps réel ou postérieurement à la mesure sauvegardée, avec (ou non) un filtrage, avec (ou non) détection automatique de la fracture (elle peut rester humaine) et déclenchement automatique d'une réaction (arrêt du traitement thermique), ou simple information à l'utilisateur, etc.

## Revendications

1. Procédé de suivi d'un traitement thermique d'un substrat microtechnologique, comportant les étapes suivantes :
- placement de ce substrat à traiter dans une zone de chauffage,
- appliquer audit substrat à traiter un traitement thermique dans des conditions de température prédéterminées, tout en surveillant l'évolution au cours du temps de l'état mécaniquement vibratoire du substrat à traiter,
- détecter une fracture du substrat à traiter par reconnaissance, dans l'évolution de l'état vibratoire au cours du temps, d'un pic caractéristique d'une fracture.

2. Procédé selon la revendication 1, **caractérisé en ce que** l'on surveille l'évolution au cours du temps de l'état vibratoire du substrat à traiter par surveillance de l'état vibratoire d'un support sur lequel ce substrat à traiter est situé.

3. Procédé selon la revendication 2, **caractérisé en ce que** le support comporte une partie située à l'extérieur de la zone de chauffage et la surveillance de son état vibratoire se fait à partir de cette partie située à l'extérieur.

4. Procédé selon l'une quelconque des revendications 1 à 3, **caractérisé en ce que**, le traitement thermique étant destiné à la production de couches microtechnologiques, on applique au substrat à traiter, préalablement au traitement thermique, une préparation qui comporte une fragilisation par implantation d'ions ou d'espèces gazeuses.

5. Procédé selon la revendication 4, **caractérisé en ce que** cette préparation comporte la solidarisation de ce substrat fragilisé à un second substrat.

6. Procédé selon l'une quelconque des revendications 1 à 3, **caractérisé en ce que**, préalablement au traitement thermique, on applique au substrat une préparation qui comporte le collage de ce substrat à un second substrat.

7. Procédé selon la revendication 6, **caractérisé en ce que** ce collage est un collage moléculaire.

8. Procédé selon l'une quelconque des revendications 1 à 7, **caractérisé en ce que** le substrat est à base de silicium.

9. Procédé selon l'une quelconque des revendications 1 à 8, **caractérisé en ce que** l'on surveille l'état vibratoire au moyen d'un capteur de vibrations.

10. Procédé selon la revendication 9, **caractérisé en ce que** ce capteur est un capteur piézo-électrique.

11. Procédé selon l'une quelconque des revendications 1 à 10, **caractérisé en ce que**, le traitement thermique ayant pour fonction de provoquer au moins une fracture de substrat pour une formation de couche microtechnologique, on interrompt le traitement thermique lorsqu'on a détecté un nombre de pics correspondant au nombre de fractures de substrats attendu en conséquence du traitement thermique.

12. Procédé selon la revendication 11, **caractérisé en ce que** l'on prépare plusieurs substrats, on les met dans la zone de chauffage sur un même support, on applique un même traitement thermique auxdits substrats en surveillant l'état vibratoire dudit support, le nombre de fracture de substrats attendu étant égal au nombre desdits substrats.

13. Procédé selon l'une quelconque des revendications 1 à 10, **caractérisé en ce que** l'on prépare plusieurs substrats, on les met dans la zone de chauffage sur un même support, on applique un même traitement thermique auxdits substrats en surveillant l'état vibratoire dudit support, ce traitement thermique étant destiné à être suivi par une étape au cours de laquelle une fracture de chacun des substrats est prévue et on interrompt le traitement thermique dès qu'une fracture est détectée.

14. Procédé selon l'une quelconque des revendications 1 à 13, **caractérisé en ce qu'**on reconnaît un pic caractéristique d'une fracture par la présence d'alternances rapprochées et d'amplitudes décroissantes.

15. Dispositif de suivi d'un traitement thermique d'un substrat microtechnologique, comportant :
- un four comportant un support adapté à recevoir des substrats à traiter,
- un dispositif de commande de ce four,
**caractérisé en ce qu'**il comporte en outre un capteur de vibrations mécaniques adapté à capter des vibrations subies par le support, ce capteur étant relié à un ensemble de traitement du signal de ce capteur.

16. Dispositif selon la revendication 15, **caractérisé en ce que** l'ensemble de traitement est connecté au dispositif de commande du four.

17. Dispositif selon la revendication 15 ou la revendication 16, **caractérisé en ce que** le capteur est un capteur piézo-électrique.

## Claims

1. Method for monitoring heat treatment of a microtechnological substrate, including the following steps:
- placing the substrate to be treated in a heating zone,
- applying heat treatment to said substrate to be treated under predetermined temperature conditions and monitoring the evolution over time of the vibratory mechanical state of the substrate to be treated,
- detecting fracture of the substrate to be treated by recognizing a peak characteristic of a fracture in the evolution over time of the vibratory state.

2. Method according to claim 1, **characterised in that** the evolution over time of the vibratory state of the substrate to be treated is monitored by monitoring the vibratory state of a support on which the substrate to be treated is situated.

3. Method according to claim 2, **characterised in that** the support includes a portion outside the heating zone and its vibratory state is monitored via said outside portion.

4. Method according to any one of claims 1 to 3, **characterised in that**, the heat treatment being intended for the production of microtechnological layers, the substrate to be treated is prepared prior to the heat treatment by weakening it by implanting ions or gaseous species.

5. Method according to claim 4, **characterised in that** preparation includes fastening the weakened substrate to a second substrate.

6. Method according to any one of claims 1 to 3, **characterised in that** the substrate is submitted prior to the heat treatment to a preparation including bonding the substrate to a second substrate.

7. Method according to claim 6, **characterised in that** the bonding is molecular bonding.

8. Method according to any one of claims 1 to 7, **characterised in that** the substrate is based on silicon.

9. Method according to any one of claims 1 to 8, **characterised in that** the vibratory state is monitored by a vibration sensor.

10. Method according to claim 9, **characterised in that** the sensor is a piezo-electric sensor.

11. Method according to any one of claims 1 to 10, **characterised in that**, the heat treatment having the function of bringing about at least one fracture of the substrate for the formation of a microtechnological layer, the heat treatment is interrupted when a number of peaks have been detected corresponding to the number of substrate fractures expected as a consequence of the heat treatment.

12. Method according to claim 11, **characterised in that** a number of substrates are prepared and placed in the heating zone on the same support, the same heat treatment is applied to said substrates, and the vibratory state of said support is monitored, the number of substrate fractures expected being equal to the number of substrates.

13. Method according to any one of claims 1 to 10, **characterised in that** a number of substrates are prepared and placed in the heating zone on the same support, the same heat treatment is applied to said substrate and the vibratory state of said support is monitored, the heat treatment being followed by a step in which each of the substrates is fractured and the heat treatment is interrupted as soon as a fracture is detected.

14. Method according to any one of claims 1 to 13, **characterised in that** a peak characteristic of a fracture is recognized by the presence of alternations that are close together and of decreasing amplitude.

15. Device for monitoring heat treatment of a microtechnological substrate, including:
- a furnace including a support adapted to receive substrates to be treated, and
- a control device of the furnace,
**characterised in that** it further includes a mechanical vibration sensor adapted to sense vibration of the support and connected to a system for processing the signal from the sensor.

16. Device according to claim 15, **characterised in that** the processing system is connected to the furnace control device.

17. Device according to claim 15 or claim 16, **characterised in that** the sensor is a piezo-electric sensor.

## Patentansprüche

1. Verfahren zur Überwachung einer Wärmebehandlung eines mikrotechnologischen Substrats, umfassend die folgenden Schritte:
- Einbringen des zu behandelnden Substrats in eine Erhitzungszone,
- an dem zu behandelnden Substrat eine Wärmebehandlung unter vorbestimmten Temperaturbedingungen vornehmen, wobei die Entwicklung des mechanischen Schwingungszustands des zu behandelnden Substrats im Lauf der Zeit überwacht wird,
- einen Bruch des zu behandelnden Substrats durch Erkennen eines für einen Bruch charakteristischen Peaks in der Entwicklung des Schwingungszustands im Lauf der Zeit erfassen.

2. Verfahren nach Anspruch 1, **dadurch gekennzeichnet, dass** man die Entwicklung des Schwingungszustands des zu behandelnden Substrats im Lauf der Zeit durch Überwachung des Schwingungszustands eines Halters überwacht, auf dem sich das zu behandelnde Substrat befindet.

3. Verfahren nach Anspruch 2, **dadurch gekennzeichnet, dass** der Halter einen außerhalb der Erhitzungszone gelegenen Teil umfasst und die Überwachung seines Schwingungszustands ausgehend von diesem außerhalb gelegenen Teil stattfindet.

4. Verfahren nach einem der Ansprüche 1 bis 3, **dadurch gekennzeichnet, dass**, wenn die Wärmebehandlung für die Herstellung von mikrotechnologischen Schichten bestimmt ist, man an das zu behandelnde Substrat vor der Wärmebehandlung eine Vorbehandlung anlegt, die eine Fragilisierung durch Implantation von Ionen oder gasförmigen Spezies umfasst.

5. Verfahren nach Anspruch 4, **dadurch gekennzeichnet, dass** die Vorbehandlung die feste Verbindung des fragilisierten Substrats mit einem zweiten Substrat umfasst.

6. Verfahren nach einem der Ansprüche 1 bis 3, **dadurch gekennzeichnet, dass** man an dem Substrat vor der Wärmebehandlung eine Vorbehandlung vornimmt, die das Verklebten dieses Substrats mit einem zweiten Substrat umfasst.

7. Verfahren nach Anspruch 6, **dadurch gekennzeichnet, dass** die Verklebung eine molekulare Verklebung ist.

8. Verfahren nach einem der Ansprüche 1 bis 7, **dadurch gekennzeichnet, dass** das Substrat auf Siliciumbasis ist.

9. Verfahren nach einem der Ansprüche 1 bis 8, **dadurch gekennzeichnet, dass** man den Schwingungszustand mit Hilfe eines Schwingungsfühlers überwacht.

10. Verfahren nach Anspruch 9, **dadurch gekennzeichnet, dass** der Fühler ein piezoelektrischer Fühler ist.

11. Verfahren nach einem der Ansprüche 1 bis 10, **dadurch gekennzeichnet, dass**, wenn die Wärmebehandlung die Aufgabe hat, mindestens einen Substratbruch für die Bildung einer mikrotechnologischen Schicht zu bewirken, man die Wärmebehandlung unterbricht, wenn man eine Anzahl von Peaks erfasst hat, die der erwarteten Anzahl von Brüchen von Substraten infolge der Wärmebehandlung entspricht.

12. Verfahren nach Anspruch 11, **dadurch gekennzeichnet, dass** man mehrere Substrate vorbereitet, man sie in der Erhitzungszone auf einem gemeinsamen Halter anordnet, man an diesen Substraten ein und dieselbe Wärmebehandlung vornimmt, indem man den Schwingungszustand des Halters überwacht, wobei die erwartete Anzahl von Brüchen von Substraten gleich der Anzahl der Substrate ist.

13. Verfahren nach einem der Ansprüche 1 bis 10, **dadurch gekennzeichnet, dass** man mehrere Substrate vorbereitet, man sie in der Erhitzungszone auf einem gemeinsamen Halter anordnet, man an den Substraten ein und dieselbe Wärmebehandlung vornimmt, indem man den Schwingungszustand des Halters überwacht, wobei diese Wärmebehandlung dazu bestimmt ist, durch einen Schritt überwacht zu werden, in dem ein Bruch jedes der Substrate vorgesehen ist, und man die Wärmebehandlung unterbricht, sobald ein Bruch erfasst wird.

14. Verfahren nach einem der Ansprüche 1 bis 13, **dadurch gekennzeichnet, dass** man einen für einen Bruch charakteristischen Peak durch das Auftreten von einander angenäherten Polwechseln und von abnehmenden Amplituden erkennt.

15. Vorrichtung zur Überwachung einer Wärmebehandlung eines mikrotechnologischen Substrats, umfassend:
- einen Ofen, der einen Halter umfasst, der dafür ausgelegt ist, zu behandelnde Substrate auszunehmen,
- eine Vorrichtung zur Steuerung des Ofens,
**dadurch gekennzeichnet, dass** sie außerdem einen Fühler für mechanische Schwingungen umfasst, der dafür ausgelegt ist, auf den Halter ausgeübte Schwingungen zu erfassen, wobei der Fühler mit einer Einheit zur Verarbeitung des Signals dieses Fühlers verbunden ist.

16. Vorrichtung nach Anspruch 15, **dadurch gekennzeichnet, dass** die Verarbeitungseinheit an die Vorrichtung zur Steuerung des Ofens angeschlossen ist.

17. Vorrichtung nach Anspruch 15 oder Anspruch 16, **dadurch gekennzeichnet, dass** der Fühler ein piezoelektrischer Fühler ist.
